# EUROPEAN PATENT SPECIFICATION

(11) **EP 4 149 233 B1**
(45) Date of publication and mention of the grant of the patent: **17.06.2026**
(21) Application number: 22194256.8
(22) Date of filing: 07.09.2022
(51) Int. Cl.: H10K 59/38, H10K 59/80

(54) **DISPLAY APPARATUS**
ANZEIGEVORRICHTUNG
APPAREIL D'AFFICHAGE

(30) Priority: 08.09.2021 KR 20210119853
(43) Date of publication of application: 15.03.2023
(73) Proprietor: Samsung Display Co., Ltd., Yongin-si, Gyeonggi-do 17113 (KR)
(72) Inventor: Lee, Kyeuk, 17113 Giheung-gu, Yongin-si, Gyeonggi-do (KR); Lee, Ansu, 17113 Giheung-gu, Yongin-si, Gyeonggi-do (KR); Kim, Sunkwang, 17113 Giheung-gu, Yongin-si, Gyeonggi-do (KR); Lee, Geunho, 17113 Giheung-gu, Yongin-si, Gyeonggi-do (KR)
(74) Representative: Dr. Weitzel & Partner

(56) References cited:
- JP-A- 2015 128 027
- US-A1- 2019 371 866
- US-A1- 2020 161 579
- US-A1- 2020 350 516
- HILMI VOLKAN DEMIR ET AL: "Quantum dot integrated LEDs using photonic and excitonic color conversion", NANO TODAY, ELSEVIER, AMSTERDAM, NL, vol. 6, no. 6, 23 October 2011 (2011-10-23), pages 632 - 647, XP028337238, ISSN: 1748-0132, [retrieved on 20111101], DOI: 10.1016/J.NANTOD.2011.10.006

## Description

The present invention relates to a display apparatus.

A display apparatus typically includes pixels for displaying images in response to input signals. The pixels emits light having different colors. Mixture of light of different colors from neighboring pixels may undesirably affect the quality of displayed images which is the underlying problem of the invention.

US 2019/371866 A1 and US 2020/161579 A1 respectively discloses a display apparatus comprising a first substrate and a second substrate overlapping each other, a first light-emitting element arranged between the first substrate and the second substrate and including a first emission area for emitting first light, a refractive layer arranged between the first light-emitting element and the second substrate, including a first structure for concentrating the first light and including a face positioned between the first substrate and the first structure, a first color filter layer arranged between the first emission area and the second substrate, and a first quantum dot layer overlapping the first emission area. Further reference is made to JP 2015 128027 A, HILMI VOLKAN DEMIR ET AL: "Quantum dot integrated LEDs using photonic and excitonic color conversion", NANO TODAY, ELSEVIER, AMSTERDAM, NL, vol. 6, no. 6, 23 October 2011 (2011-10-23), pages 632-647, XP028337238, ISSN: 1748-0132, DOI: 10.1016/J.NANTOD.2011.10.006, and US 2020/350516 A1.

It is the object of the invention to solve the above problem. Such will be achieved by the display apparatus as per claim 1. Embodiments covered by the invention are defined in the subclaims.

According to the invention the display apparatus includes a first , e.g. lower, substrate and a second, e.g. upper, substrate overlapping each other. The display apparatus further comprises a first light-emitting element arranged between the first substrate and the second substrate and including a first emission area for emitting first light; a refractive layer arranged between the first light-emitting element and the second substrate, including a first structure for concentrating the first light, and including a face positioned between the first substrate and the first structure; a first color filter layer arranged between the first emission area and the second substrate; a first quantum dot layer overlapping the first emission area, and a planarization layer arranged between the refractive layer and the second substrate; wherein the first quantum dot layer is directly arranged on the planarization layer; the planarization layer directly contacts the refractive layer, and a refractive index of the planarization layer is greater than a refractive index of the refractive layer.

The upper surface of the refractive layer may include a concave portion which is concave in a direction of a lower surface of the lower substrate.

The concave portion may be provided as one or more concave portions.

The concave portion may overlap the first emission area.

According to the present embodiment, each of the first color filter layer and the first quantum dot layer may overlap the first emission area.

The display apparatus may further include an opaque-material member between the first (lower) substrate and the second (upper) substrate including a first opening corresponding to the first emission area, the first quantum dot layer filling the first opening, a second light-emitting element arranged on the lower substrate and including a second emission area, a second color filter layer at least partially overlapping the second emission area, arranged on the lower surface of the upper substrate, and including a fourth opening overlapping the first opening, and a second quantum dot layer between the second light-emitting element and the second color filter layer.

The display apparatus may further include a third light-emitting element arranged on the lower substrate and including a third emission area, a third color filter layer at least partially overlapping the third emission area, arranged on the lower surface of the upper substrate, and including a fifth opening overlapping the first opening, and a light transmission layer between the third light-emitting element and the third color filter layer.

The opaque-material member may further include a second opening corresponding to the second emission area, and a third opening corresponding to the third emission area, and the second quantum dot layer may fill the second opening, and the light transmission layer may fill the third opening.

The first light-emitting element, the second light-emitting element, and the third light-emitting element may emit light in a same wavelength band.

The display apparatus may further include a thin-film encapsulation layer between the first light-emitting element and the refractive layer, wherein the thin-film encapsulation layer may include a first inorganic layer, an organic layer, and a second inorganic layer, which are sequentially stacked.

The refractive layer may be directly arranged on the second inorganic layer.

The refractive layer and the second inorganic layer may be provided as one body.

The display apparatus may further include a filler between the lower substrate and the upper substrate.

The filler may be between the refractive layer and the planarization layer.

The filler may be between the planarization layer and the first quantum dot layer.

The filler may be between the thin-film encapsulation layer and the refractive layer.

The display apparatus may further include a protective layer between the planarization layer and the first quantum dot layer.

The display apparatus may further include a column spacer between the refractive layer and the opaque-material member.

According to one or more embodiments, a display apparatus may include the lower substrate, the first light-emitting element, a second light-emitting element, and a third light-emitting element which are arranged on the lower substrate, the first light-emitting element including the first emission area, the second light-emitting element including a second emission area, and the third light-emitting element including a third emission area, the upper substrate arranged above the lower substrate so that the first to third light-emitting elements are between the lower substrate and the upper substrate, the refractive layer between the first to third light-emitting elements and the upper substrate, the first color filter layer, a second color filter layer, and a third color filter layer which are arranged on a lower surface of the upper substrate in a direction of the lower substrate, and the first quantum dot layer, a second quantum dot layer, and a light transmission layer which overlap the first color filter layer, the second color filter layer, and the third color filter layer, respectively, wherein an upper surface of the refractive layer has a shape to concentrate light emitted from the first light-emitting element, the second light-emitting element, and the third light-emitting element.

The upper surface of the refractive layer may include a concave portion which is concave in a direction of a lower surface of the lower substrate.

The concave portion may be provided to correspond to each of the first light-emitting element, the second light-emitting element, and the third light-emitting element.

The display apparatus further includes the planarization layer between the refractive layer and the upper substrate.

The planarization layer is directly arranged on the refractive layer.

The planarization layer has a refractive index greater than a refractive index of the refractive layer.

The first light-emitting element, the second light-emitting element, and the third light-emitting element may emit light in a same wavelength band.

The display apparatus may further include a thin-film encapsulation layer between the first light-emitting element and the refractive layer, wherein the thin-film encapsulation layer may include a first inorganic layer, an organic layer, and a second inorganic layer, which are sequentially stacked.

The refractive layer may be directly arranged on the second inorganic layer.

The refractive layer and the second inorganic layer may be provided as one body.

The refractive layer arranged between the first light-emitting element and the second substrate may include a flat face positioned between the first substrate and the first structure.

The display apparatus may include an opaque-material member. The opaque-material member may include a first opening corresponding to the first emission area. The first quantum dot layer may fill the first opening.

The first structure may be a recess and may be concave toward the face and toward the first emission area (for the overlying member to form a convex lens).

The first structure may include one or more concave portions.

The refractive index of the material of the planarization layer may be greater than the refractive index of the material of the refractive layer.

The planarization layer may be partially positioned inside the first structure.

The display apparatus may include the following elements: a second light-emitting element arranged between the first substrate and the second substrate and may include a second emission area; a second color filter layer overlapping the second emission area, arranged between the second emission area and the second substrate, and may include a second-color-filter opening corresponding to the first opening; and a second quantum dot layer arranged between the second emission area and the second color filter layer.

The display apparatus may include the following elements: a third light-emitting element arranged between the first substrate and the second substrate and may include a third emission area; a third color filter layer overlapping the third emission area, arranged between the third emission area and the second substrate, and may include a third-color-filter opening corresponding to the first opening; and a light transmission layer arranged between the third emission area and the third color filter layer.

The opaque-material member may include a second opening corresponding to the second emission area and may include a third opening corresponding to the third emission area. The second quantum dot layer may fill the second opening. The light transmission layer may fill the third opening.

The first light-emitting element, the second light-emitting element, and the third light-emitting element may emit light in a same wavelength band.

The display apparatus may include the following elements: a first inorganic layer; and an organic layer arranged between the first inorganic layer and the refractive layer.

The display apparatus may include a second inorganic layer. The refractive layer may be directly arranged on the second inorganic layer.

The refractive layer may directly contact the organic layer.

The display apparatus may include a filler between the first substrate and the second substrate.

The filler may be partially positioned inside the first structure of the refractive layer.

The filler may be between the refractive layer and the first quantum dot layer.

The filler may be between the organic layer and the refractive layer.

The display apparatus may include a protective layer between the refractive layer and the first quantum dot layer.

The display apparatus may include a column spacer between the refractive layer and the opaque-material member.

### BRIEF DESCRIPTION OF THE DRAWINGS

FIG. 1 is a schematic perspective view of a display apparatus according to an embodiment.
FIG. 2 is a schematic cross-sectional view of a display apparatus according to an embodiment.
FIG. 3 is a diagram for describing a first quantum dot layer, a second quantum dot layer, and a light transmission layer included in a display apparatus according to an embodiment.
FIG. 4 is a schematic cross-sectional view of a display apparatus according to an embodiment.
FIG. 5 is a schematic cross-sectional view of a display apparatus according to an embodiment.
FIG. 6 is a schematic cross-sectional view of a display apparatus according to an embodiment.
FIG. 7 is a schematic cross-sectional view of a display apparatus according to an embodiment.
FIG. 8 is a schematic cross-sectional view of a display apparatus according to an embodiment.
FIG. 9 is a schematic cross-sectional view of a display apparatus according to an embodiment.
FIG. 10 is a schematic cross-sectional view of a display apparatus according to an embodiment.

### DETAILED DESCRIPTION

Examples of embodiments are described with reference to the accompanying drawings. Like reference numerals may refer to like elements. Practical embodiments may have different forms and should not be construed as being limited to the described examples.

Although the terms "first," "second," etc. may be used herein to describe various elements, these elements should not be limited by these terms. These elements may be used to distinguish one element from another. A first element may be termed a second element without departing from teachings of one or more embodiments. The description of an element as a "first" element may not require or imply the presence of a second element or other elements. The terms "first," "second," etc. may be used to differentiate different categories or sets of elements. For conciseness, the terms "first," "second," etc. may represent "first-category (or first-set)," "second-category (or second-set)," etc., respectively.

Singular forms may indicate plural forms unless the context clearly indicates otherwise.

That the terms "comprising" and/or "including" may specify the presence of stated features or elements, but may not preclude the presence or addition of one or more other features or elements.

When a first element is referred to as being "on" a second element, the first element may be directly or indirectly on the second element. One or more intervening elements may be present between the first element and the second element.

Dimensions illustrated in the drawings may be exaggerated or reduced for convenience of explanation. Embodiments are not limited to the illustrated dimensions.

The term "connect" may mean "directly connect" or "indirectly connect." The term "connect" may mean "mechanically connect" and/or "electrically connect." The term "connected" may mean "electrically connected" or "electrically connected through no intervening transistor." The term "insulate" may mean "electrically insulate" or "electrically isolate." The term "conductive" may mean "electrically conductive." The term "drive" may mean "operate" or "control." The term "include" may mean "be made of." The term "adjacent" may mean "immediately adjacent." The expression that an element extends in a particular direction may mean that the element extends lengthwise in the particular direction and/or that the lengthwise direction of the element is in the particular direction. The expression that a space or opening overlaps or corresponds to an object may mean that (the position of) the space or opening overlaps with (the position of) and/or exposes the object. The term "overlap" may be equivalent to "be overlapped by." The term "shape" may mean "structure."

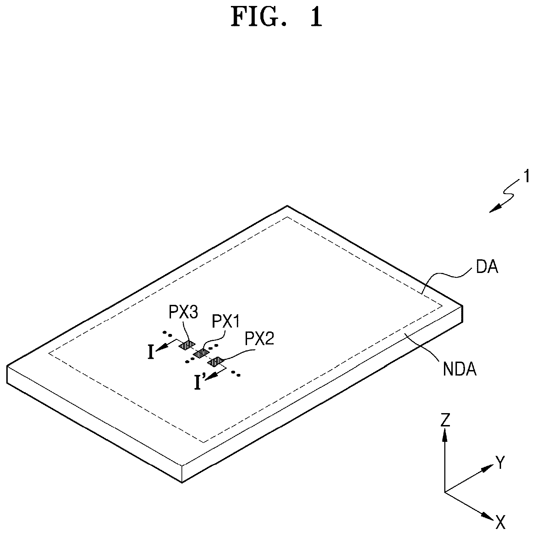

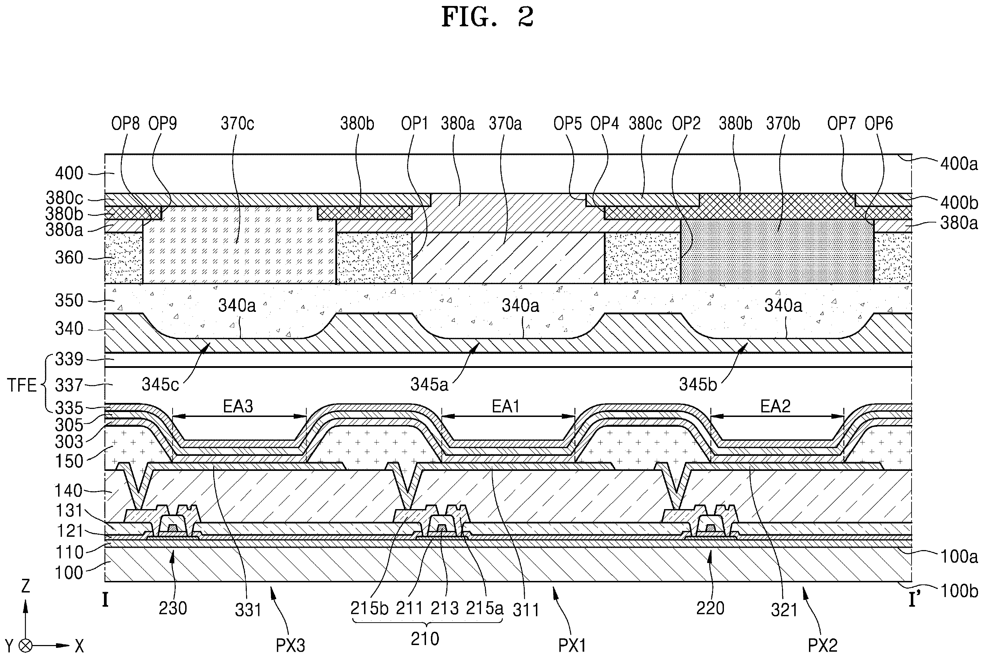

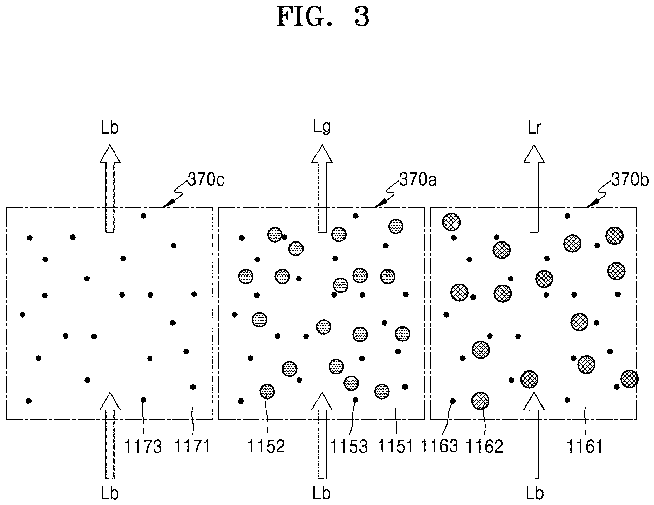

FIG. 1 is a schematic perspective view of a display apparatus 1 according to an embodiment. FIG. 2 is a schematic cross-sectional view of a display apparatus according to an embodiment. FIG. 3 is a diagram for describing a first quantum dot layer, a second quantum dot layer, and a light transmission layer, which are included in a display apparatus according to an embodiment. FIG. 2 is a cross-sectional view of the display apparatus taken along line I-I' of FIG. 1.

Referring to FIGS. 1, 2, and 3, the display apparatus 1 includes a display area DA in which an image is displayed in response to input signals and includes a non-display area NDA in which no image may be displayed in response to input signals. The display apparatus 1 provides an image through an array of pixels PX two-dimensionally arranged in the display area DA.

The non-display area NDA entirely or substantially surrounds the display area DA. A driver and/or a main power line that provides an electric signal or power to pixel circuits may be arranged in the non-display area NDA. The non-display area NDA may include a pad to which electronic elements, printed circuit boards, or the like may be electrically connected.

The display area DA may have a polygonal shape, such as a quadrangle shape illustrated in FIG. 1. The display area DA may have one or more shapes, such as a square shape, a rectangular shape, an ellipse shape, and/or a circle shape.

The display apparatus 1 includes a lower substrate 100, a light-emitting element, a thin-film encapsulation layer TFE, a refractive layer 340, a first quantum dot layer 370a, a second quantum dot layer 370b, a light transmission layer 370c, a first color filter layer 380a, a second color filter layer 380b, a third color filter layer 380c, and an upper substrate 400.

The lower substrate 100 may include glass, a metal, or a polymer resin. The lower substrate 100 may be flexible and/or bendable and may include one or more flexible and/or bendable materials, for example, a polymer resin such as polyethersulfone, polyacrylate, polyether imide, polyethylene naphthalate, polyethylene terephthalate, polyphenylene sulfide, polyarylate, polyimide, polycarbonate, or cellulose acetate propionate. The lower substrate 100 may have a multi-layered structure including two polymer layers each including a polymer resin and including a barrier layer between the two polymer layers. The barrier layer may include an inorganic material (such as silicon oxide, silicon nitride, and/or silicon oxynitride).

A first light-emitting element including a first pixel electrode 311, a second light-emitting element including a second pixel electrode 321, and a third light-emitting element including a third pixel electrode 331 may be arranged over the lower substrate 100. A first thin-film transistor 210 electrically connected to the first light-emitting element, a second thin-film transistor 220 electrically connected to the second light-emitting element, and a third thin-film transistor 230 electrically connected to the third light-emitting element may also be arranged over the lower substrate 100.

Referring to FIG. 2, the first pixel electrode 311 of the first light-emitting element is electrically connected to the first thin-film transistor 210. The second pixel electrode 321 of the second light-emitting element is electrically connected to the second thin-film transistor 220. The third pixel electrode 331 of the third light-emitting element is electrically connected to the third thin-film transistor 230.

The first thin-film transistor 210 and the first pixel electrode 311 are described. The second thin-film transistor 220 and the third thin-film transistor 230 may each have a structure the same as or similar to that of the first thin-film transistor 210.

The first thin-film transistor 210 may include a first semiconductor layer 211, a first gate electrode 213, a first source electrode 215a, and a first drain electrode 215b. The first semiconductor layer 211 may include amorphous silicon, polycrystalline silicon, an organic semiconductor material, or an oxide semiconductor material. The first gate electrode 213 may include one or more conductive materials and have one or more layered structures. The first gate electrode 213 may include a molybdenum (Mo) layer and an aluminum (Al) layer. The first gate electrode 213 may have a layered structure of Mo-Al-Mo. The first gate electrode 213 may include a titanium nitride (TiNₓ) layer, an Al layer, and/or a Ti layer. The first source electrode 215a and the first drain electrode 215b may include one or more conductive materials and have one or more layered structures. The first source electrode 215a and the first drain electrode 215b may include a titanium (Ti) layer, an Al layer, and/or a copper (Cu) layer. The first source electrode 215a and the first drain electrode 215b may each have a layered structure of Ti-Al-Ti.

To provide insulation between the first semiconductor layer 211 and the first gate electrode 213, a gate insulating layer 121 may be between the first semiconductor layer 211 and the first gate electrode 213. The gate insulating layer 121 may include an inorganic material such as silicon oxide, silicon nitride, and/or silicon oxynitride. An interlayer insulating layer 131 may be arranged on the first gate electrode 213. The interlayer insulating layer 131 may include an inorganic material such as silicon oxide, silicon nitride, and/or silicon oxynitride. The first source electrode 215a and the first drain electrode 215b may be arranged on the interlayer insulating layer 131. The gate insulating layer 121 and/or the interlayer insulating layer 131 may be formed through chemical vapor deposition (CVD) or atomic layer deposition (ALD).

A buffer layer 110 may be between the first thin-film transistor 210 and the lower substrate 100. The buffer layer 110 may include an inorganic material such as silicon oxide, silicon nitride, and/or silicon oxynitride. The buffer layer 110 may increase the flatness of the upper surface of the lower substrate 100 and/or may prevent or significantly reduce penetration of impurities from the lower substrate 100 into the first semiconductor layer 211 of the first thin-film transistor 210.

An organic insulating layer 140 may be arranged on the first thin-film transistor 210. The organic insulating layer 140 may provide a generally flat surface over the first thin-film transistor 210. The organic insulating layer 140 may include an organic material, for example, acryl, benzocyclobutene (BCB) or hexamethyldisiloxane (HMDSO). The organic insulating layer 140 may be a single layer or may have multiple layers.

The first light-emitting element, the second light-emitting element, and the third light-emitting element may be arranged on the organic insulating layer 140. The first light-emitting element may be arranged in a first pixel PX1, the second light-emitting element may arranged in a second pixel PX2, and the third light-emitting element may be arranged in a third pixel PX3.

The first light-emitting element arranged in the first pixel PX1 may be an organic light-emitting element including a first pixel electrode 311, a portion of an opposite electrode 305, and a portion of an intermediate layer 303 between the electrodes 311 and 305. The intermediate layer 303 may include an emission layer. The second light-emitting element arranged in the second pixel PX2 may be an organic light-emitting element including a second pixel electrode 321, a portion of the opposite electrode 305, and a portion of the intermediate layer 303 between the electrodes 321 and 305. The third light-emitting element arranged in the third pixel PX3 may be an organic light-emitting element including a third pixel electrode 331, a portion of the opposite electrode 305, and a portion of the intermediate layer 303 between the electrodes 331 and 305.

Referring to FIG. 2, the first pixel electrode 311 may be electrically connected to the first thin-film transistor 210 by contacting one of the first source electrode 215a and the first drain electrode 215b through an opening formed in the organic insulating layer 140. The second pixel electrode 321 may be electrically connected to the second thin-film transistor 220 through an opening formed in the organic insulating layer 140. The third pixel electrode 331 may be electrically connected to the third thin-film transistor 230 through an opening formed in the organic insulating layer 140.

The first pixel electrode 311 may include a light-transmissive conductive layer and a reflective layer. The light-transmissive conductive layer may include a light-transmissive conductive oxide such as indium tin oxide (ITO), indium oxide (In₂O₃), or indium zinc oxide (IZO). The reflective layer may include a metal such as Al or silver (Ag). The first pixel electrode 311 may have a three-layered structure of ITO-Ag-ITO. The second pixel electrode 321 and the third pixel electrode 331 may include the same material(s) as the first pixel electrode 311.

An intermediate layer 303 including the emission layer may have a shape corresponding to the first pixel electrode 311. Referring to FIG. 2, the intermediate layer 303 may be formed as one body over the first to third pixel electrodes 311 to 331. The opposite electrode 305 may also be formed as one body over the first to third pixel electrodes 311 to 331. The opposite electrode 305 may include a light-transmissive conductive layer and a semi-transmissive layer. The light-transmissive conductive layer may include ITO, In₂O₃, or IZO. The semi-transmissive layer may include a metal such as Al or Ag. The opposite electrode 305 may include a semi-transmissive layer including magnesium and silver (MgAg).

A pixel-defining layer 150 may be arranged on the organic insulating layer 140. The pixel-defining layer 150 may define pixels by including an opening corresponding to each pixel. The pixel-defining layer 150 may include an opening that exposes a central portion of the first pixel electrode 311. The first light-emitting element may include a first emission area EA1, and the first emission area EA1 of the first light-emitting element may be defined (and exposed) by an opening in the pixel-defining layer 150. First light may be emitted from the first emission area EA1 of the first light-emitting element.

The pixel-defining layer 150 may include an opening that exposes a second emission area EA2 of the second pixel electrode 321. Second light may be emitted from the second emission area EA2 of the second light-emitting element.

The pixel-defining layer 150 may include an opening that exposes a third emission area EA3 of the third pixel electrode 331. Third light may be emitted from the third emission area EA3 of the third light-emitting element.

The pixel-defining layer 150 may prevent an arc from occurring at the edges of the first to third pixel electrodes 311 to 331 by increasing a distance between the edge of the first pixel electrode 311 and the opposite electrode 305, a distance between the edge of the second pixel electrode 321 and the opposite electrode 305, and a distance between the edge of the third pixel electrode 331 and the opposite electrode 305.

The pixel-defining layer 150 may include an organic insulating material. The pixel-defining layer 150 may include an inorganic insulating material such as silicon nitride, silicon oxynitride, or silicon oxide. The pixel-defining layer 150 may include an organic insulating material and an inorganic insulating material. The pixel-defining layer 150 may include a light blocking material, and may be black. The light blocking material may include carbon black, carbon nanotubes, a resin or a paste including black dye, metal particles (for example, nickel, aluminum, molybdenum, and/or alloy particles), metal oxide particles (e.g., chromium oxide particles), or metal nitride particles (e.g., chromium nitride particles). When the pixel-defining layer 150 includes a light blocking material, reflection of external light by metal structures arranged under the pixel-defining layer 150 may be reduced.

Though not illustrated, a spacer may be arranged on the pixel-defining layer 150. The spacer may include an organic insulating material such as polyimide. The spacer may include an inorganic insulating material such as silicon nitride (SiNₓ) or silicon oxide SiO_{X}. The spacer may include an organic insulating material and an inorganic insulating material.

The spacer and the pixel-defining layer 150 may include the same material. The pixel-defining layer 150 and the spacer may be formed together in a mask process using a halftone mask. The spacer and the pixel-defining layer 150 may include different materials.

The intermediate layer 303 including the emission layer may be arranged on the first to third pixel electrodes 311 to 331. The intermediate layer 303 may include a low molecular weight material or a polymer material. If the intermediate layer 303 includes a low molecular weight material, the intermediate layer 303 may include a hole injection layer (HIL), a hole transport layer (HTL), an emission layer (EML), an electron transport layer (ETL), an electron injection layer (ElL), etc. stacked in a single or composite structure and formed through vacuum deposition. If the intermediate layer 303 includes a polymer material, the intermediate layer 303 may include an HTL and an EML. The HTL may include poly(3,4)-ethylenedioxythiophene (PEDOT), and the EML may include a polymer material such as a poly-phenylvinylene (PPV)-based material and a polyfluorene-based material. The intermediate layer 303 may be formed by one or more of screen printing, inkjet printing, deposition, laser induced thermal imaging (LITI), etc.

The intermediate layer 303 may be patterned to include separate layers that respectively correspond to the first to third pixel electrodes 311 to 331.

The emission layer may emit light in a third/blue wavelength band. The emission layer may emit (blue) light in a wavelength band ranging from about 450 nm to about 495 nm. The emission layer may be provided as one body over the first to third pixel electrodes 311 to 331, or may be patterned to include separate layers that respectively correspond to the first to third pixel electrodes 311 to 331.

The opposite electrode 305 may be arranged on the intermediate layer 303 and may overlap the first to third pixel electrodes 311 to 331. The opposite electrode 305 may be formed as one body in a plurality of organic light-emitting elements.

The opposite electrode 305 may include a conductive material having a low work function. The opposite electrode 305 may include a (semi-)transparent layer including Ag, Mg, Al, platinum (Pt), palladium (Pd), gold (Au), nickel (Ni), neodymium (Nd), iridium (Ir), chromium (Cr), lithium (Li), calcium (Ca), or an alloy of some of the above metals. The opposite electrode 305 may further include a layer such as ITO, IZO, ZnO, or In₂O₃ over the (semi-)transparent layer.

Though not illustrated, a capping layer may be arranged on the opposite electrode 305. The capping layer may include lithium fluoride (LiF), an inorganic material, and/or an organic material.

Because the organic light-emitting elements may be damaged by external moisture, oxygen, or the like, an encapsulation layer may be provided to cover and protect the organic light-emitting elements. The encapsulation layer may be a thin-film encapsulation layer TFE including at least one inorganic layer and at least one organic layer. The thin-film encapsulation layer TFE may include a first inorganic layer 335, an organic layer 337, and a second inorganic layer 339, which are sequentially stacked.

The first inorganic layer 335 may be directly arranged on the opposite electrode 305. The first inorganic layer 335 may prevent or significantly reduce penetration of external moisture or oxygen into the first to third light-emitting elements.

The organic layer 337 may be directly arranged on the first inorganic layer 335. The organic layer 337 may provide a flat surface over the first inorganic layer 335. Curves or particles formed on the upper surface of the first inorganic layer 335 may be covered by the organic layer 337, and thus, the influence of the unevenness of the upper surface of the first inorganic layer 335 on the elements formed over the organic layer 337 may be minimized.

The second inorganic layer 339 may be directly arranged on the organic layer 337. The second inorganic layer 339 may block moisture or the like.

The first inorganic layer 335 and the second inorganic layer 339 may each include one or more of aluminum oxide, titanium oxide, tantalum oxide, hafnium oxide, zinc oxide, silicon oxide, silicon nitride, and silicon oxynitride. The first inorganic layer 335 and the second inorganic layer 339 may include a single layer or multiple layers. The organic layer 337 may include a polymer-based material. The polymer-based material may include an acryl-based resin, an epoxy-based resin, polyimide, polyethylene, or the like. The organic layer 337 may include acrylate.

The upper substrate 400 overlaps the lower substrate 100. The first light-emitting element including the first pixel electrode 311, the second light-emitting element including the second pixel electrode 321, and the third light-emitting element including the third pixel electrode 331 are between the upper substrate 400 and the lower substrate 100. The upper substrate 400 may include a polymer resin. The polymer resin may be polyethersulfone, polyacrylate, polyetherimide, polyethylene naphthalate, polyethylene terephthalate, polyphenylene sulfide, polyarylate, polyimide, polycarbonate, or cellulose acetate propionate. The upper substrate 400 may have a multi-layered structure including two polymer layers (each including a polymer resin) and a barrier layer between the polymer layers. The barrier layer may include an inorganic material (such as silicon oxide, silicon nitride, and/or silicon oxynitride). The upper substrate 400 may be flexible or bendable.

The lower substrate 100 may include an upper surface 100a and a lower surface 100b. The upper surface 100a of the lower substrate 100 may refer to a surface closer to the upper substrate 400 than the lower surface 100b of the lower substrate 100. The upper substrate 400 may include an upper surface 400a and a lower surface 400b. The lower surface 400b of the upper substrate 400 may refer to a surface closer to the lower substrate 100 than the upper surface 400a of the upper substrate 400.

The refractive layer 340 is between the lower substrate 100 and the upper substrate 400. The refractive layer 340 may be arranged on the thin-film encapsulation layer TFE. The refractive layer 340 may be directly arranged on the second inorganic layer 339.

A planarization layer 350 is between the lower substrate 100 and the upper substrate 400. The planarization layer 350 is arranged on the refractive layer 340.

An opaque-material member 360 may be between the lower substrate 100 and the upper substrate 400. The opaque-material member 360 may include one or more materials that may absorb light. The opaque-material member 360 and the pixel-defining layer 150 may include the same material or different materials. The opaque-material member 360 may include an opaque inorganic insulating material such as chromium oxide or molybdenum oxide, or may include an opaque organic insulating material such as a black resin.

The opaque-material member 360 may include an opening corresponding to (and exposing) an emission area of each light-emitting element. The opaque-material member 360 may include a first opening OP1 corresponding to the first emission area EA1 of the first light-emitting element, a second opening OP2 corresponding to the second emission area EA2 of the second light-emitting element, and a third opening OP3 corresponding to the third emission area EA3 of the third light-emitting element.

The first opening OP1, the second opening OP2, and the third opening OP3 may each correspond to an opening of the pixel-defining layer 150. The first opening OP1 of the opaque-material member 360 may correspond to an opening of the pixel-defining layer 150 defining the first emission area EA1, the second opening OP2 of the opaque-material member 360 may correspond to an opening of the pixel-defining layer 150 defining the second emission area EA2, and the third opening OP3 of the opaque-material member 360 may correspond to an opening of the pixel-defining layer 150 defining the third emission area EA3.

An area of the first opening OP1 of the opaque-material member 360 may be greater than an area of the opening of the pixel-defining layer 150 defining the first emission area EA1. In a plan view viewed in a direction (a Z-axis direction) perpendicular to the upper surface 400a of the upper substrate 400, a shape of (the edge/perimeter of) the first opening OP1 of the opaque-material member 360 is the same as or similar to a shape of (the edge/perimeter of) the first emission area EA1.

An area of the second opening OP2 of the opaque-material member 360 may be greater than an area of the opening of the pixel-defining layer 150 defining the second emission area EA2. In a plan view viewed in the direction (the Z-axis direction) perpendicular to the upper surface 400a of the upper substrate 400, a shape of (the edge/perimeter of) the second opening OP2 of the opaque-material member 360 is the same as or similar to a shape of (the edge/perimeter of) the second emission area EA2.

An area of the third opening OP3 of the opaque-material member 360 may be greater than an area of the opening of the pixel-defining layer 150 defining the third emission area EA3. In a plan view viewed in the direction (the Z-axis direction) perpendicular to the upper surface 400a of the upper substrate 400, a shape of (the edge/perimeter of) the third opening OP3 of the opaque-material member 360 is the same as or similar to a shape of (the edge/perimeter of) the third emission area EA3.

The first quantum dot layer 370a may be arranged in the first opening OP1 of the opaque-material member 360, the second quantum dot layer 370b may be arranged in the second opening OP2 of the opaque-material member 360, and the light transmission layer 370c may be arranged in the third opening OP3 of the opaque-material member 360.

The first quantum dot layer 370a, the second quantum dot layer 370b, and the light transmission layer 370c may be arranged on the planarization layer 350. The first quantum dot layer 370a, the second quantum dot layer 370b, and the light transmission layer 370c may be directly arranged on the planarization layer 350.

FIG. 3 is a diagram for describing a first quantum dot layer, a second quantum dot layer, and a light transmission layer included in a display apparatus according to an embodiment.

Referring to FIGS. 2 and 3, the first quantum dot layer 370a may fill the first opening OP1 of the opaque-material member 360. The first quantum dot layer 370a may convert the light in the third wavelength band generated from the intermediate layer 303 arranged on the first pixel electrode 311 into light in a first wavelength band. For example, light in the wavelength band ranging from about 450 nm to about 495 nm may be generated from the intermediate layer 303, and the first quantum dot layer 370a may convert this light into light in a wavelength band ranging from about 495 nm to about 570 nm. Accordingly, in the first pixel PX1, light Lg in a wavelength band ranging from about 495 nm to about 570 nm may be emitted to the outside through the upper substrate 400.

The first quantum dot layer 370a may include a first photosensitive polymer 1151 in which first quantum dots 1152 and first scattering particles 1153 are dispersed. The first quantum dots 1152 may be excited by blue light Lb to isotropically emit the green light Lg having a wavelength longer than a wavelength of the blue light Lb. The first photosensitive polymer 1151 may include a light-transmissive organic material. The first scattering particles 1153 scatter the blue light Lb that is not absorbed by the first quantum dots 1152 so that more first quantum dots 1152 are excited, thereby increasing color conversion efficiency. The first scattering particles 1153 may be/include, for example, titanium oxide (TiO₂) or metal particles. The first quantum dots 1152 may include at least one of a Group II-VI compound, a Group III-V compound, a Group IV-VI compound, a Group IV element, and a Group IV compound.

The second quantum dot layer 370b may fill the second opening OP2 of the opaque-material member 360. The second quantum dot layer 370b may convert the light in the third wavelength band generated from the intermediate layer 303 arranged on the second pixel electrode 321 into light in a second wavelength band. For example, light in the wavelength band ranging from about 450 nm to about 495 nm may be generated from the intermediate layer 303, and the second quantum dot layer 370b may convert this light into light in a wavelength band ranging from about 630 nm to about 780 nm. Accordingly, in the second pixel PX2, the light in the wavelength band ranging from about 630 nm to about 780 nm may be emitted to the outside through the upper substrate 400.

The second quantum dot layer 370b may include a second photosensitive polymer 1161 in which second quantum dots 1162 and second scattering particles 1163 are dispersed. The second quantum dots 1162 may be excited by blue light Lb to isotropically emit red light Lr having a wavelength longer than the wavelength of the blue light Lb. The second photosensitive polymer 1161 may include a light-transmissive organic material. The second scattering particles 1163 scatter the blue light Lb that is not absorbed by the second quantum dots 1162 so that more second quantum dots 1162 are excited, thereby increasing color conversion efficiency. The second scattering particles 1163 may be/include, for example, TiO₂ or metal particles. The second quantum dots 1162 may include at least one of a Group II-VI compound, a Group III-V compound, a Group IV-VI compound, a Group IV element, and a Group IV compound. The second quantum dots 1162 and the first quantum dots 1152 may include the same material. Sizes of the second quantum dots 1162 may be greater than sizes of the first quantum dots 1152.

The light transmission layer 370c may transmit the blue light Lb. The light transmission layer 370c may include a third photosensitive polymer 1171 in which third scattering particles 1173 are dispersed. The third photosensitive polymer 1171 may include a light-transmissive organic material such as a silicone resin or an epoxy resin, and may include the same material as the first and second photosensitive polymers 1151 and 1161. The third scattering particles 1173 may scatter and emit the blue light Lb, and may include the same material as the first and second scattering particles 1153 and 1163.

The first quantum dot layer 370a, the second quantum dot layer 370b, and the light transmission layer 370c are respectively formed in the first opening OP1, the second opening OP2, and the third opening OP3 of the opaque-material member 360 by inkjet printing.

The first color filter layer 380a, the second color filter layer 380b, and the third color filter layer 380c may be arranged on the lower surface 400b of the upper substrate 400. The first color filter layer 380a may be directly arranged on the first quantum dot layer 370a, the second color filter layer 380b may be directly arranged on the second quantum dot layer 370b, and the third color filter layer 380c may be directly arranged on the light transmission layer 370c. Accordingly, the light converted by the first quantum dot layer 370a may be directly incident on the first color filter layer 380a, the light converted by the second quantum dot layer 370b may be directly incident on the second color filter layer 380b, and the light passing through the light transmission layer 370c may be directly incident on the third color filter layer 380c.

The first color filter layer 380a, the second color filter layer 380b, and the third color filter layer 380c may transmit light having wavelengths belonging to different wavelength bands. The first color filter layer 380a may transmit only light having a wavelength belonging to the first wavelength band, the second color filter layer 380b may transmit only light having a wavelength belonging to the second wavelength band, and the third color filter layer 380c may transmit only light having a wavelength belonging to the third wavelength band. The first wavelength band may be about 495 nm to about 570 nm, the second wavelength band may be about 630 nm to about 780 nm, and the third wavelength band may be about 450 nm to about 495 nm.

The first color filter layer 380a may overlap the first light-emitting element including the first pixel electrode 311. The first color filter layer 380a may overlap the first emission area EA1 of the first light-emitting element. Accordingly, light emitted from the first light-emitting element may pass through the first color filter layer 380a.

The second color filter layer 380b may overlap the second light-emitting element including the second pixel electrode 321. The second color filter layer 380b may overlap the second emission area EA2 of the second light-emitting element. Accordingly, light emitted from the second light-emitting element may pass through the second color filter layer 380b.

The third color filter layer 380c may overlap the third light-emitting element including the third pixel electrode 331. The third color filter layer 380c may overlap the third emission area EA3 of the third light-emitting element. Accordingly, light emitted from the third light-emitting element may pass through the third color filter layer 380c.

A sixth opening OP6 and an eighth opening OP8 may be formed in the first color filter layer 380a. The sixth opening OP6 of the first color filter layer 380a may overlap the second color filter layer 380b, and the eighth opening OP8 of the first color filter layer 380a may overlap the third color filter layer 380c.

A fourth opening OP4 and a ninth opening OP9 may be formed in the second color filter layer 380b. The fourth opening OP4 of the first color filter layer 380a may overlap the first color filter layer 380a, and the ninth opening OP9 of the second color filter layer 380b may overlap the third color filter layer 380c.

A fifth opening OP5 and a seventh opening OP7 may be formed in the third color filter layer 380c. The fifth opening OP5 of the third color filter layer 380c may overlap the first color filter layer 380a, and the seventh opening OP7 of the third color filter layer 380c may overlap the second color filter layer 380b.

At least a portion of the first color filter layer 380a may be exposed through the fourth opening OP4 of the second color filter layer 380b and the fifth opening OP5 of the third color filter layer 380c. The first color filter layer 380a may be in direct contact with the lower surface 400b of the upper substrate 400 through the fourth opening OP4 and the fifth opening OP5. An inorganic layer may be between the first color filter layer 380a and the upper substrate 400. The first color filter layer 380a may overlap the first quantum dot layer 370a in a direction (e.g., a -Z direction) toward the lower surface 100b of the lower substrate 100, and the first color filter layer 380a may overlap the lower surface 400b of the upper substrate 400 in a direction (e.g., a +Z direction) toward the upper surface 400a of the upper substrate 400. The second color filter layer 380b and the third color filter layer 380c may not be significantly present between the first color filter layer 380a and the first quantum dot layer 370a and between the first color filter layer 380a and the upper substrate 400.

Accordingly, in the first pixel PX1, light having a wavelength belonging to the first wavelength band may be emitted to the outside through the upper substrate 400. Light in the third wavelength band emitted from the first light-emitting element is converted into light in the first wavelength band when passing through the first quantum dot layer 370a and is filtered when passing through the first color filter layer 380a; thus, in the first pixel PX1, light having a wavelength belonging to the first wavelength band may be emitted to the outside through the upper substrate 400. The light emitted from the first light-emitting element passes through the first quantum dot layer 370a and the first color filter layer 380a, so that color purity of the light emitted through the upper substrate 400 may be improved.

At least a portion of the second color filter layer 380b may be exposed through the sixth opening OP6 of the first color filter layer 380a and the seventh opening OP7 of the third color filter layer 380c. The second color filter layer 380b may be in direct contact with the second quantum dot layer 370b through the sixth opening OP6, and the second color filter layer 380b may be in contact with the lower surface 400b of the upper substrate 400 through the seventh opening OP7. An inorganic layer may be between the color filter layer 380b and the upper substrate 400. The second color filter layer 380b may overlap the second quantum dot layer 370b in the direction (e.g., the -Z direction) toward the lower surface 100b of the lower substrate 100, and the second color filter layer 380b may overlap the lower surface 400b of the upper substrate 400 in the direction (e.g., the +Z direction) toward the upper surface 400a of the upper substrate 400. The first color filter layer 380a and the third color filter layer 380c may not be significantly present between the second color filter layer 380b and the second quantum dot layer 370b and between the second color filter layer 380b and the upper substrate 400.

Accordingly, in the second pixel PX2, light having a wavelength belonging to the second wavelength band may be emitted to the outside through the upper substrate 400. Light in the third wavelength band emitted from the second light-emitting element is converted into light in the second wavelength band when passing through the second quantum dot layer 370b and is filtered when passing through the second color filter layer 380b; thus, in the second pixel PX2, light having a wavelength belonging to the second wavelength band may be emitted to the outside through the upper substrate 400. The light emitted from the second light-emitting element passes through the second quantum dot layer 370b and the second color filter layer 380b, so that the color purity of the light emitted through the upper substrate 400 may be improved.

At least a portion of the third color filter layer 380c may be exposed through the eighth opening OP8 of the first color filter layer 380a and the ninth opening OP9 of the second color filter layer 380b. The third color filter layer 380c may be in direct contact with the light transmission layer 370c through the eighth opening OP8 and the ninth opening OP9. An inorganic layer may be between the third color filter layer 380c and the upper substrate 400. The third color filter layer 380c may overlap the light transmission layer 370c in the direction (e.g., the -Z direction) toward the lower surface 100b of the lower substrate 100, and the third color filter layer 380c may overlap the lower surface 400b of the upper substrate 400 in the direction (e.g., the +Z direction) toward the upper surface 400a of the upper substrate 400. The first color filter layer 380a and the second color filter layer 380b may not be significantly present between the third color filter layer 380c and the light transmission layer 370c and between the third color filter layer 380c and the upper substrate 400

Accordingly, in the third pixel PX3, light having a wavelength belonging to the third wavelength band may be emitted to the outside through the upper substrate 400. Light in the third wavelength band emitted from the third light-emitting element passes through the light transmission layer 370c and is filtered when passing through the third color filter layer 380c; thus, in the third pixel PX3, light having a wavelength belonging to the third wavelength band may be emitted to the outside through the upper substrate 400. The light emitted from the third light-emitting element passes through the light transmission layer 370c and the third color filter layer 380c, so that the color purity of the light emitted through the upper substrate 400 may be improved.

Portions of at least two color filter layers may overlap each other between every two the first pixel PX1, the second pixel PX2, and the third pixel PX3. FIG. 2 illustrates that portions of the first color filter layer 380a, the second color filter layer 380b, and the third color filter layer 380c are between every two of the first pixel PX1, the second pixel PX2, and the third pixel PX3. These overlapping portions of the color filter layers may serve as light-blocking members. No visible light may substantially pass through these overlapping portions.

Portions of the first color filter layer 380a, the second color filter layer 380b, and the third color filter layer 380c may overlap each other between the upper substrate 400 and the opaque-material member 360. A distance between the upper substrate 400 and the opaque-material member 360 may be kept constant.

If an upper surface 340a of the refractive layer 340 is flat, light emitted from the first light-emitting element of the first pixel PX1 may be significantly incident on the second quantum dot layer 370b or the light transmission layer 370c, possibly causing a significant color mixing defect. If the upper surface 340a of the refractive layer 340 is flat, external light may be significantly incident on the first, second, and third pixel electrodes 311, 321, and 331 of the light-emitting elements, and a significant reflected color may be undesirably generated.

The upper surface 340a of the refractive layer 340 may have a structure configured to concentrate light emitted from the first to third light-emitting elements. The upper surface 340a of the refractive layer 340 may have a concave shape in the direction (e.g., the -Z direction) toward the lower surface 100b of the lower substrate 100. As long as the light emitted from the first to third light-emitting elements may be concentrated, the upper surface 340a of the refractive layer 340 may have one or more other structures. The lower face of the refractive layer 340 may be positioned between the lower substrate 100 and the light-concentrating structure(s).

The light-concentrating structure(s) may include a first concave portion 345a, a second concave portion 345b, and a third concave portion 345c, which are concave in the direction (e.g., the -Z direction) toward the lower surface 100b of the lower substrate 100, formed in the upper surface 340a of the refractive layer 340. The first concave portion 345a may correspond to the first light-emitting element. The second concave portion 345b may correspond to the second light-emitting element. The third concave portion 345c may correspond to the third light-emitting element. The overlying planarization layer 350 may include convex lens structures respectively filling the concave portions 345a, 345b, and 345c.

The first concave portion 345a of the upper surface 340a of the refractive layer 340 may overlap the first emission area EA1 of the first light-emitting element. The first concave portion 345a may concentrate light emitted from the first light-emitting element. The first concave portion 345a may cause direct the light emitted from the first light-emitting element toward the first quantum dot layer 370a. Accordingly, the light emitted from the first light-emitting element may be substantially prevented from being incident on the second quantum dot layer 370b or the light transmission layer 370c. Advantageously, satisfactory light efficiency and image display quality of the display apparatus may be attained.

FIG. 2 illustrates that one first concave portion 345a corresponds to the first emission area EA1 of the first light-emitting element. The first concave portion 345a may be/include one or more concave portions. The first concave portion 345a may include two concave portions. FIG. 2 illustrates two concave portions of the first concave portion 345a respectively correspond to two edges of the first emission area EA1. A plurality of first concave portions 345a may be formed in the upper surface 340a of the refractive layer 340 and may overlap the first emission area EA1 of the first light-emitting element.

The second concave portion 345b of the upper surface 340a of the refractive layer 340 may overlap the second emission area EA2 of the second light-emitting element. The second concave portion 345b may concentrate light emitted from the second light-emitting element arranged thereunder. The second concave portion 345b may direct the light emitted from the second light-emitting element toward the second quantum dot layer 370b. Accordingly, the light emitted from the second light-emitting element may be substantially prevented from being incident on the first quantum dot layer 370a or the light transmission layer 370c. Advantageously, satisfactory image display quality and light efficiency of the display apparatus may be attained.

FIG. 2 illustrates that one second concave portion 345b corresponds to the second emission area EA2 of the second light-emitting element. The second concave portion 345b may be/include one or more second concave portions 345b. The second concave portion 345b may include two concave portions. FIG. 2 illustrates two concave portions of the first concave portion 345b respectively correspond to two edges of the second emission area EA2. A plurality of second concave portions 345b may be formed in the upper surface 340a of the refractive layer 340 and may overlap the second emission area EA2 of the second light-emitting element.

The third concave portion 345c of the upper surface 340a of the refractive layer 340 may overlap the third emission area EA3 of the third light-emitting element. The third concave portion 345c may concentrate light emitted from the third light-emitting element. The third concave portion 345c may direct the light emitted from the third light-emitting element toward the light transmission layer 370c. Accordingly, the light emitted from the third light-emitting element may be substantially prevented from being incident on the first quantum dot layer 370a or the second quantum dot layer 370b. Advantageously, satisfactory image display quality and light efficiency of the display apparatus may be attained.

FIG. 2 illustrates that one third concave portion 345c corresponds to the third emission area EA3 of the third light-emitting element. The third concave portion 345c may be one or more third concave portions 345c. The third concave portion 345c may be/include two concave portions 345c. FIG. 2 illustrates two concave portions of the first concave portion 345c respectively correspond to two edges of the third emission area EA3. A plurality of third concave portions 345c may be formed in the upper surface 340a of the refractive layer 340 and may overlap the third emission area EA3 of the third light-emitting element.

The refractive layer 340 may include an inorganic material and/or a metal, and the planarization layer 350 may include an organic material. The refractive layer 340 may include one or more inorganic materials, such as aluminum oxide, titanium oxide, tantalum oxide, hafnium oxide, zinc oxide, silicon oxide, silicon nitride, and/or silicon oxynitride, and/or may include a metal such as Mo, Al, Cu, Ti, and/or the like.

When light travels from one medium to another medium, the light may be refracted at an interface between the medias. An angle between a line perpendicular to the interface of the two media and incident light is an angle of incidence. An angle between the line perpendicular to the interface of the two media and refracted light is an angle of refraction. The angle of incidence is greater than the angle of refraction when the light travels from a medium with a relatively lower refractive index to a medium with a relatively higher refractive index.

The refractive layer 340 and the planarization layer 350 have different refractive indices. The planarization layer 350 has a refractive index greater than a refractive index of the refractive layer 340. Accordingly, light refracted at an interface between the refractive layer 340 and the planarization layer 350 may be concentrated.

The light emitted from the first light-emitting element may be refracted at the interface between the refractive layer 340 and the planarization layer 350. Since the refractive index of the planarization layer 350 is greater than the refractive index of the refractive layer 340, the light refracted at the interface between the refractive layer 340 and the planarization layer 350 may be directed to the first quantum dot layer 370a and may be substantially prevented from being incident on the second quantum dot layer 370b or the light transmission layer 370c. Advantageously, satisfactory image display quality and light efficiency of the display apparatus may be attained.

The light emitted from the second light-emitting element may be refracted at the interface between the refractive layer 340 and the planarization layer 350. Since the refractive index of the planarization layer 350 is greater than the refractive index of the refractive layer 340, the light refracted at the interface between the refractive layer 340 and the planarization layer 350 may be directed to the second quantum dot layer 370b and may be substantially prevented from being incident on the first quantum dot layer 370a or the light transmission layer 370c. Advantageously, satisfactory image display quality and light efficiency of the display apparatus may be attained.

The light emitted from the third light-emitting element may be refracted at the interface between the refractive layer 340 and the planarization layer 350. Since the refractive index of the planarization layer 350 is greater than the refractive index of the refractive layer 340, the light refracted at the interface between the refractive layer 340 and the planarization layer 350 may be directed to the light transmission layer 370c and may be substantially prevented from being incident on the first quantum dot layer 370a or the second quantum dot layer 370b. Advantageously, satisfactory image display quality and light efficiency of the display apparatus may be attained.

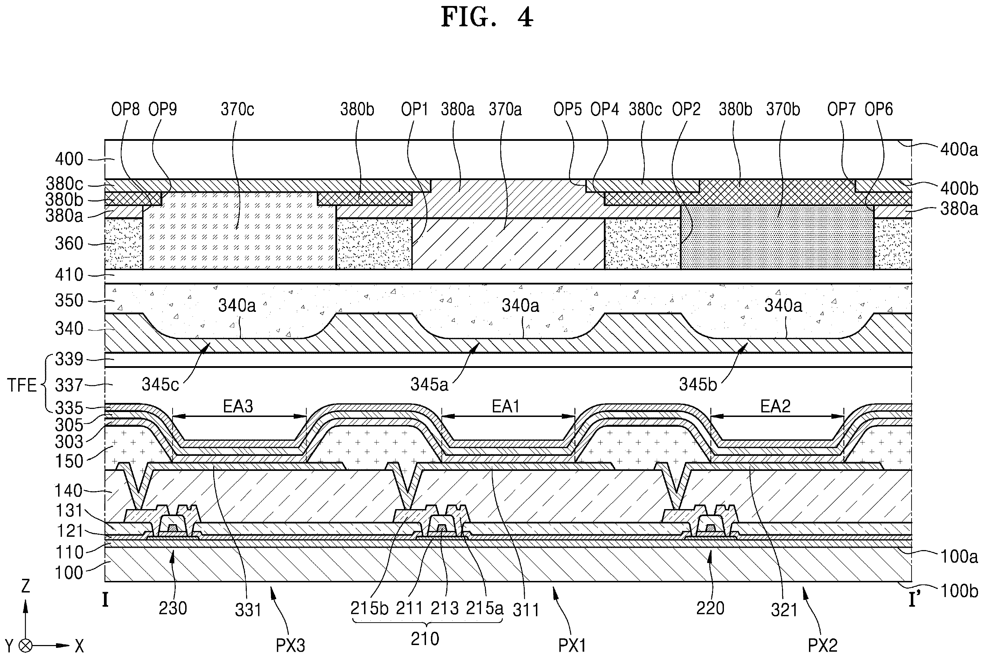

FIG. 4 is a schematic cross-sectional view of a display apparatus according to an embodiment. The structure illustrated in FIG. 4 is different from the structure illustrated in FIG. 2 in that a protective layer 410 is between the planarization layer 350 and the first quantum dot layer 370a. In FIG. 4, the same reference numerals as those in FIG. 2 denote the same elements or similar elements.

Referring to FIG. 4, the protective layer 410 may be between the planarization layer 350 and the first quantum dot layer 370a. The protective layer 410 may be entirely arranged on the planarization layer 350. The protective layer 410 may be between the planarization layer 350 and the first quantum dot layer 370a, between the planarization layer 350 and the second quantum dot layer 370b, and between the planarization layer 350 and the light transmission layer 370c.

The protective layer 410 may protect the first quantum dot layer 370a, the second quantum dot layer 370b, and the light transmission layer 370c.

The protective layer 410 may include an organic material and/or an inorganic material and may be/include a single layer or multiple layers. The protective layer 410 may include a general commercial polymer (such as BCB, polyimide (PI), HMDSO, poly(methyl 2-methylpropenoate) (PMMA), or polystyrene (PS)), a polymer derivative having a phenol-based group, an acryl-based polymer, an imide-based polymer, an aryl ether-based polymer, an amide-based polymer, a fluorine-based polymer, a p-xylene-based polymer, and/or a vinyl alcohol-based polymer. The protective layer 410 may include SiO_{X}, SiN_{X}, silicon oxynitride (SiO_{X}N_{Y}), aluminum oxide (Al₂O₃), TiO₂, tantalum oxide (Ta₂O₅), hafnium oxide (HfO₂), or zinc oxide (ZnO).

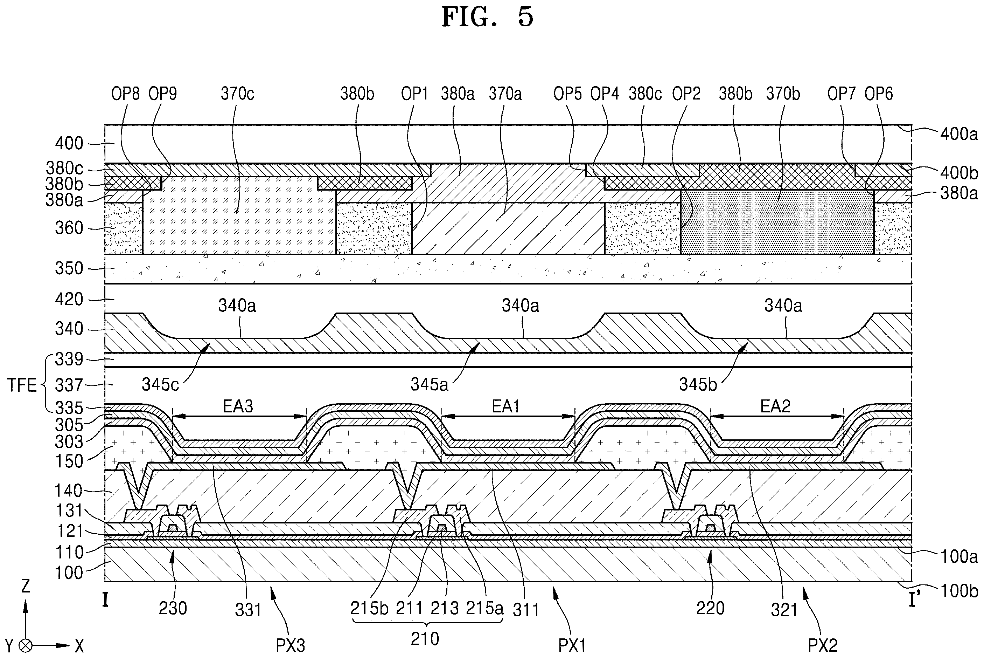

Each of FIGS. 5, 6, and 7 is a schematic cross-sectional view of a display apparatus, according to an embodiment. The structures illustrated in FIGS. 5, 6, and 7 are different from the structure illustrated in FIG. 2 in that a filler 420 is provided between the lower substrate 100 and the upper substrate 400. In FIGS. 5, 6, and 7, the same reference numerals as those in FIG. 2 denote the same elements or similar elements.

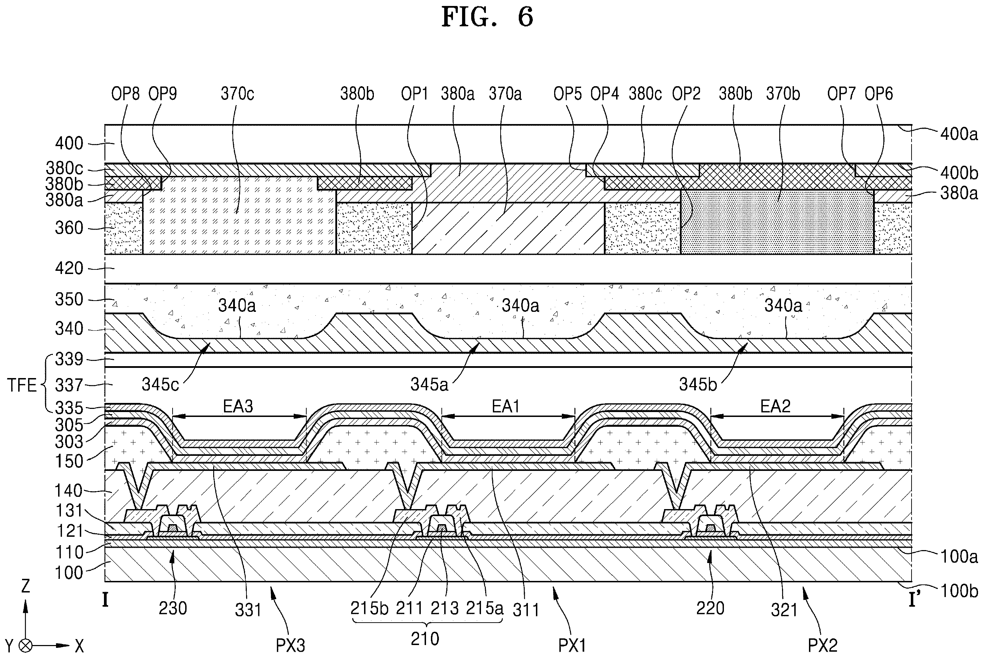

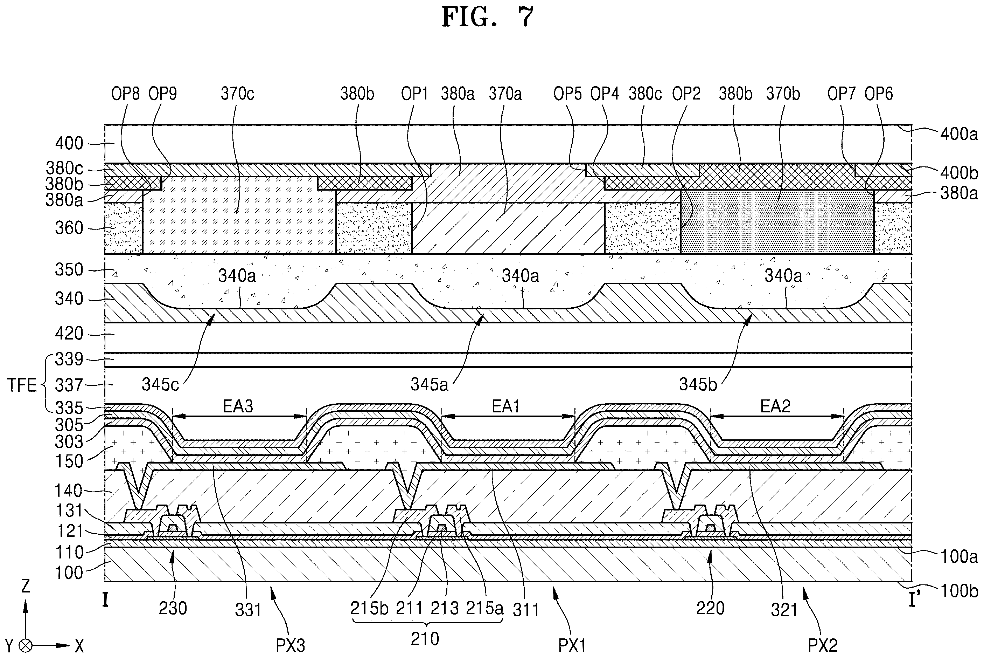

Referring to FIG. 5, the filler 420 may be between the refractive layer 340 and the planarization layer 350. Referring to FIG. 6, the filler 420 may be between the planarization layer 350 and the first quantum dot layer 370a. The filler 420 may be between the planarization layer 350 and the first quantum dot layer 370a, between the planarization layer 350 and the second quantum dot layer 370b, and between the planarization layer 350 and the light transmission layer 370c. Referring to FIG. 7, the filler 420 may be between the thin-film encapsulation layer TFE and the refractive layer 340. The filler 420 may be between the second inorganic layer 339 and the refractive layer 340.

The filler 420 may buffer an external pressure. The filler 420 may include an organic material such as methyl silicone, phenyl silicone, or polyimide. The filler 420 may include a urethane-based resin, an epoxy-based resin, and/or an acryl-based resin (i.e., one or more organic sealants), and/or may include silicone (which is an inorganic sealant).

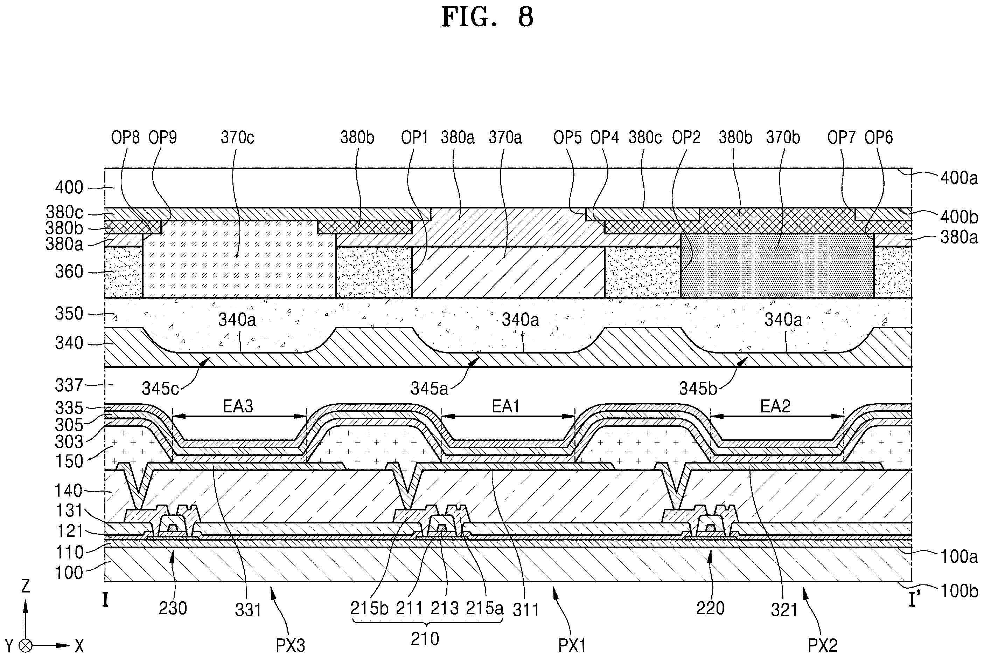

FIG. 8 is a schematic cross-sectional view of a display apparatus according to an embodiment. The structure illustrated in FIG. 8 is different from the structure illustrated in FIG. 2 in that the second inorganic layer 339 (see FIG. 2) and the refractive layer 340 are one body. In FIG. 8, the same reference numerals as those in FIG. 2 denote similar elements or the same elements.

Referring to FIG. 8, because the organic light-emitting elements may be damaged by external moisture, oxygen, or the like, an encapsulation layer may be provided to cover and protect the organic light-emitting elements. The encapsulation layer may include a first inorganic layer 335 and an organic layer 337 stacked on the first inorganic layer 335.

The first inorganic layer 335 may be directly arranged on the opposite electrode 305. The first inorganic layer 335 may prevent or significantly reduce penetration of external moisture or oxygen into the first to third light-emitting elements.

The organic layer 337 may be directly arranged on the first inorganic layer 335. The organic layer 337 may provide a flat surface over the first inorganic layer 335. Curves or particles formed on the upper surface of the first inorganic layer 335 may be covered by the organic layer 337; thus, the influence of the unevenness of the upper surface of the first inorganic layer 335 on the elements formed over the organic layer 337 may be minimized.

The refractive layer 340 may be between the lower substrate 100 and the upper substrate 400. The refractive layer 340 may be directly arranged on the organic layer 337. The refractive layer 340 may block moisture.

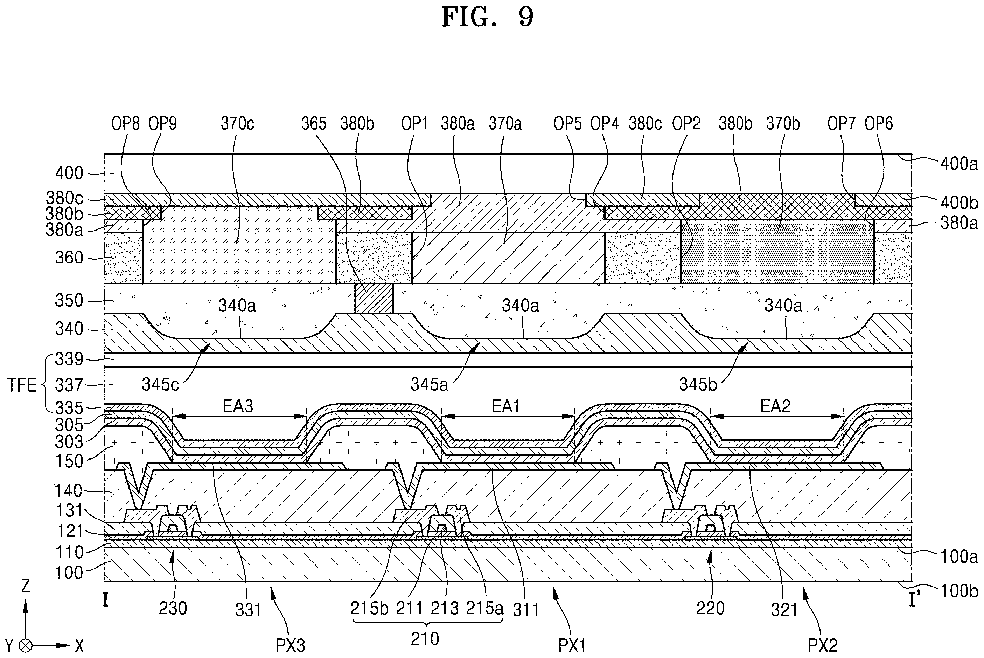

FIG. 9 is a schematic cross-sectional view of a display apparatus according to an embodiment. The structure illustrated in FIG. 9 is different from the structure illustrated in FIG. 2 in that a column spacer 365 is arranged in the planarization layer 350. In FIG. 9, the same reference numerals as those in FIG. 2 denote similar elements or the same elements.

Referring to FIG. 9, the column spacer 365 may be provided between the lower substrate 100 and the upper substrate 400, so that a gap between the lower substrate 100 and the upper substrate 400 may be kept constant.

The column spacer 365 may be arranged in the planarization layer 350. The column spacer 365 may be directly arranged on the refractive layer 340. The opaque-material member 360 may be arranged on the column spacer 365. The opaque-material member 360 may be directly arranged on the column spacer 365. The opaque-material member 360 and the column spacer 365 may overlap each other.

The column spacer 365 may overlap the pixel-defining layer 150. The column spacer 365 may not overlap the first, second, and third emission areas EA1, EA2, and EA3 of the light-emitting elements.

The column spacer 365 and the opaque-material member 360 may include the same material. The column spacer 365 and the opaque-material member 360 may include different materials.

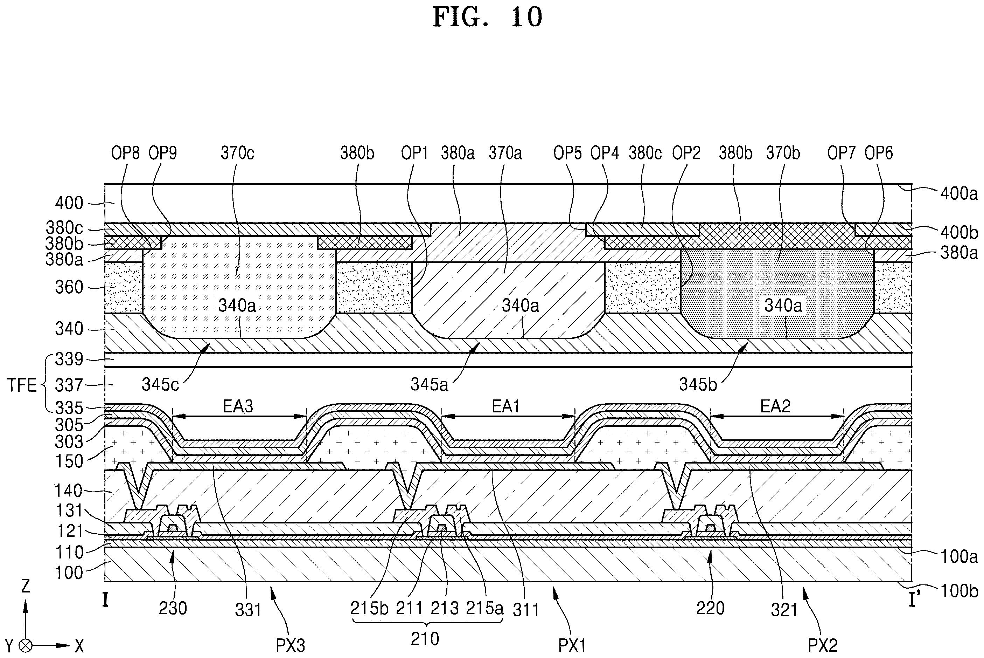

FIG. 10 is a schematic cross-sectional view of a display apparatus according to an embodiment. The structure illustrated in FIG. 10 is different from the structure illustrated in FIG. 2 in that the planarization layer 350 arranged on the refractive layer 340 is optional. In FIG. 10, the same reference numerals as those in FIG. 2 denote similar elements or the same elements.

Referring to FIG. 10, the refractive layer 340 may be between the lower substrate 100 and the upper substrate 400. The refractive layer 340 may be arranged on the thin-film encapsulation layer TFE. The refractive layer 340 may be directly arranged on the second inorganic layer 339.

The first quantum dot layer 370a, the second quantum dot layer 370b, and the light transmission layer 370c may be arranged on the refractive layer 340. The first quantum dot layer 370a, the second quantum dot layer 370b, and the light transmission layer 370c may be directly arranged on the refractive layer 340 and may fill the corresponding concave structures (or corresponding recesses) of the refractive layer 340. Accordingly, light passing through the refractive layer 340 may be directly incident on the first quantum dot layer 370a, the second quantum dot layer 370b, and the light transmission layer 370c.

According to embodiments, a display apparatus with satisfactory efficiency and/or satisfactory image display quality may be implemented.

The described embodiments are illustrative and are not for purposes of limitation. Description of features or aspects within each embodiment should typically be considered as available for other similar features or aspects in other embodiments. Various changes may be made in the described embodiments without departing from the scope defined by the following claims.

## Claims

1. A display apparatus (1) comprising:
a first substrate (100) and a second substrate (400) overlapping each other;
a first light-emitting element arranged between the first substrate (100) and the second substrate (400) and including a first emission area (EA1) for emitting first light;
a refractive layer (340) arranged between the first light-emitting element and the second substrate (400), including a first structure for concentrating the first light, and including a face positioned between the first substrate (100) and the first structure;
a first color filter layer (380a) arranged between the first emission area (EA1) and the second substrate (400);
a first quantum dot layer (370a) overlapping the first emission area (EA1), and
a planarization layer (350) arranged between the refractive layer (340) and the second substrate (400); wherein
the first quantum dot layer (370a) is directly arranged on the planarization layer (350);
the planarization layer (350) directly contacts the refractive layer (340), and
a refractive index of the planarization layer (350) is greater than a refractive index of the refractive layer (340).

2. The display apparatus (1) of claim 1, wherein the first structure is concave toward the first emission area (EA1).

3. The display apparatus (1) of at least one of claims 1 or 2, wherein the first structure includes one or more concave portions (345a, 345b, 345c).

4. The display apparatus (1) of at least one of claims 1 to 3, wherein the planarization layer (350) is partially positioned inside the first structure.

5. The display apparatus (1) of at least one of claims 1 to 4, further comprising:
an opaque-material member (360) between the first substrate (100) and the second substrate (400) including a first opening (OP1) corresponding to the first emission area (EA1), the first quantum dot layer (370a) filling the first opening (OP1);
a second light-emitting element arranged between the first substrate (100) and the second substrate (400) and including a second emission area (EA2);
a second color filter layer (380b) overlapping the second emission area (EA2), arranged between the second emission area (EA2) and the second substrate (400), and including a second-color-filter opening (OP4) corresponding to the first opening (OP1); and
a second quantum dot layer (370b) arranged between the second emission area (EA2) and the second color filter layer (380b).

6. The display apparatus (1) of claim 5, further comprising:
a third light-emitting element arranged between the first substrate (100) and the second substrate (400) and including a third emission area (EA3);
a third color filter layer (380c) overlapping the third emission area (EA3), arranged between the third emission area (EA3) and the second substrate (400), and including a third-color-filter opening (OP5) overlapping the first opening (OP1); and
a light transmission layer (370c) arranged between the third emission area (EA3) and the third color filter layer (380c).

7. The display apparatus (1) of claim 6, the opaque-material member (360) including a second opening (OP2) corresponding to the second emission area (EA2) and a third opening (OP3) corresponding to the third emission area (EA3), wherein the second quantum dot layer (370b) fills the second opening (OP2), and the light transmission layer (370c) fills the third opening (OP3).

8. The display apparatus (1) of at least one of claims 6 or 7, wherein the first light-emitting element, the second light-emitting element, and the third light-emitting element emit light in a same wavelength band.

9. The display apparatus (1) of at least one of claims 1 to 8, further comprising:
a first inorganic layer (335); and
an organic layer (337) arranged between the first inorganic layer (335) and the refractive layer (340).

10. The display apparatus (1) of claim 9, further comprising a second inorganic layer (339), wherein the refractive layer (340) is directly arranged on the second inorganic layer (339).

11. The display apparatus (1) of claim 9, wherein the refractive layer (340) directly contacts the organic layer (337).

12. The display apparatus (1) of at least one of claims 9 to 11, further comprising a filler (420) positioned between the first substrate (100) and the second substrate (400), or partially inside the first structure of the refractive layer (340), or between the refractive layer (340) and the first quantum dot layer (370a), or between the organic layer (337) and the refractive layer (340).

13. The display apparatus (1) of at least one of claims 1 to 12, further comprising a protective layer (410) between the refractive layer (340) and the first quantum dot layer (370a).

14. The display apparatus (1) of at least one of claims 1 to 13, further comprising:
an opaque-material member (360) including a first opening (OP1), wherein the first quantum dot layer (370a) is positioned in the first opening (OP1); and
a column spacer (365) between the refractive layer (340) and the opaque-material member (360).

## Patentansprüche

1. Eine Anzeigevorrichtung (1), umfassend:
ein erstes Substrat (100) und ein zweites Substrat (400), die einander überlappen;
ein erstes lichtemittierendes Element, angeordnet zwischen dem ersten Substrat (100) und dem zweiten Substrat (400) und umfassend einen ersten Emissionsbereich (EA1) zum Emittieren von erstem Licht;
eine Brechschicht (340), angeordnet zwischen dem ersten lichtemittierenden Element und dem zweiten Substrat (400), umfassend eine erste Struktur zum Konzentrieren des ersten Lichts, und umfassend eine Fläche, die zwischen dem ersten Substrat (100) und der ersten Struktur positioniert ist;
eine erste Farbfilterschicht (380a), angeordnet zwischen dem ersten Emissionsbereich (EA1) und dem zweiten Substrat (400);
eine erste Quantenpunkt-Schicht (370a), die den ersten Emissionsbereich (EA1) überlappt; und
eine Planarisierungsschicht (350), angeordnet zwischen der Brechschicht (340) und dem zweiten Substrat (400); wobei
wie erste Quantenpunkt-Schicht (370a) direkt auf der Planarisierungsschicht (350) angeordnet ist;
die Planarisierungsschicht (350) direkt die Brechschicht (340) kontaktiert; und
ein Brechungsindex der Planarisierungsschicht (350) größer ist als ein Brechungsindex der Brechschicht (340).

2. Die Anzeigevorrichtung (1) nach Anspruch 1, wobei die erste Struktur konkav zu dem ersten Emissionsbereich (EA1) ist.

3. Die Anzeigevorrichtung (1) nach mindestens einem der Ansprüche 1 oder 2, wobei die erste Struktur einen oder mehrere konkave Abschnitte (345a, 345b, 345c) umfasst.

4. Die Anzeigevorrichtung (1) nach mindestens einem der Ansprüche 1 bis 3, wobei die Planarisierungsschicht (350) teilweise innerhalb der ersten Struktur positioniert ist.

5. Die Anzeigevorrichtung (1) nach mindestens einem der Ansprüche 1 bis 4, ferner umfassend:
ein Opakmaterialelement (360) zwischen dem ersten Substrat (100) und dem zweiten Substrat (400), umfassend eine erste Öffnung (OP1), entsprechend dem ersten Emissionsbereich (EA1), wobei die erste Quantenpunkt-Schicht (370a) die erste Öffnung (OP1) füllt;
ein zweites lichtemittierendes Element, angeordnet zwischen dem ersten Substrat (100) und dem zweiten Substrat (400) und umfassend einen zweiten Emissionsbereich (EA2);
eine zweite Farbfilterschicht (380b), die den zweiten Emissionsbereich (EA2) überlappt, angeordnet zwischen dem zweiten Emissionsbereich (EA2) und dem zweiten Substrat (400), und umfassend eine zweite Farbfilter-Öffnung (OP4), entsprechend der ersten Öffnung (OP1); und
eine zweite Quantenpunkt-Schicht (370b), angeordnet zwischen dem zweiten Emissionsbereich (EA2) und der zweiten Farbfilterschicht (380b).

6. Die Anzeigevorrichtung (1) nach Anspruch 5, ferner umfassend:
ein drittes lichtemittierendes Element, angeordnet zwischen dem ersten Substrat (100) und dem zweiten Substrat (400) und umfassend einen dritten Emissionsbereich (EA3);
eine dritte Farbfilterschicht (380c), die den dritten Emissionsbereich (EA3) überlappt, angeordnet zwischen dem dritten Emissionsbereich (EA3) und dem zweiten Substrat (400), und umfassend eine dritte Farbfilter-Öffnung (OP5), die die erste Öffnung (OP1) überlappt; und
eine Lichttransmissionsschicht (370c), angeordnet zwischen dem dritten Emissionsbereich (EA3) und der dritten Farbfilterschicht (380c).

7. Die Anzeigevorrichtung (1) nach Anspruch 6, wobei das Opakmaterialelement (360) eine zweite Öffnung (OP2), entsprechend dem zweiten Emissionsbereich (EA2), und eine dritte Öffnung (OP3), entsprechend dem dritten Emissionsbereich (EA3), umfasst, wobei die zweite Quantenpunkt-Schicht (370b) die zweite Öffnung (OP2) füllt, und die Lichttransmissionsschicht (370c) die dritte Öffnung (OP3) füllt.

8. Die Anzeigevorrichtung (1) nach mindestens einem der Ansprüche 6 oder 7, wobei das erste lichtemittierende Element, das zweite lichtemittierende Element und das dritte lichtemittierende Element Licht in einem gleichen Wellenlängenband emittieren.

9. Die Anzeigevorrichtung (1) nach mindestens einem der Ansprüche 1 bis 8, ferner umfassend:
eine erste anorganische Schicht (335); und
eine organische Schicht (337), angeordnet zwischen der ersten anorganischen Schicht (335) und der Brechschicht (340).

10. Die Anzeigevorrichtung (1) nach Anspruch 9, ferner umfassend eine zweite anorganische Schicht (339), wobei die Brechschicht (340) direkt auf der zweiten anorganischen Schicht (339) angeordnet ist.

11. Die Anzeigevorrichtung (1) nach Anspruch 9, wobei die Brechschicht (340) direkt die organische Schicht (337) kontaktiert.

12. Die Anzeigevorrichtung (1) nach mindestens einem der Ansprüche 9 bis 11, ferner umfassend einen Füller (420), positioniert zwischen dem ersten Substrat (100) und dem zweiten Substrat (400), oder teilweise innerhalb der ersten Struktur der Brechschicht (340), oder zwischen der Brechschicht (340) und der ersten Quantenpunkt-Schicht (370a), oder zwischen der organischen Schicht (337) und der Brechschicht (340).

13. Die Anzeigevorrichtung (1) nach mindestens einem der Ansprüche 1 bis 12, ferner umfassend eine Schutzschicht (410) zwischen der Brechschicht (340) und der ersten Quantenpunkt-Schicht (370a).

14. Die Anzeigevorrichtung (1) nach mindestens einem der Ansprüche 1 bis 13, ferner umfassend:
ein Opakmaterialelement (360), umfassend eine erste Öffnung (OP1), wobei die erste Quantenpunkt-Schicht (370a) in der ersten Öffnung (OP1) positioniert ist; und
einen Säulenabstandshalter (365) zwischen der Brechschicht (340) und dem Opakmaterialelement (360).

## Revendications

1. Appareil d'affichage (1) comprenant :
un premier substrat (100) et un deuxième substrat (400) se chevauchant l'un l'autre;
un premier élément électroluminescent disposé entre le premier substrat (100) et le deuxième substrat (400) et comportant une première zone d'émission (EA1) pour émettre une première lumière ;
une couche réfractive (340) disposée entre le premier élément électroluminescent et le deuxième substrat (400), comportant une première structure pour concentrer la première lumière, et comportant une face positionnée entre le premier substrat (100) et la première structure ;
une première couche de filtre coloré (380a) disposée entre la première zone d'émission (EA1) et le deuxième substrat (400) ;
une première couche de boîtes quantiques (370a) chevauchant la première zone d'émission (EA1), et
une couche de planarisation (350) disposée entre la couche réfractive (340) et le deuxième substrat (400) ; dans lequel
la première couche de boîtes quantiques (370a) est disposée directement sur la couche de planarisation (350) ;
la couche de planarisation (350) est en contact direct avec la couche réfractive (340), et
un indice de réfraction de la couche de planarisation (350) est supérieur à un indice de réfraction de la couche réfractive (340).

2. Appareil d'affichage (1) selon la revendication 1, dans lequel la première structure est concave vers la première zone d'émission (EA1).

3. Appareil d'affichage (1) selon au moins l'une des revendications 1 ou 2, dans lequel la première structure comporte une ou plusieurs partie(s) concave(s) (345a, 345b, 345c).

4. Appareil d'affichage (1) selon au moins l'une des revendications 1 à 3, dans lequel la couche de planarisation (350) est partiellement positionnée à l'intérieur de la première structure.

5. Appareil d'affichage (1) selon au moins l'une des revendications 1 à 4, comprenant en outre :
un élément de matériau opaque (360) entre le premier substrat (100) et le deuxième substrat (400) comportant une première ouverture (OP1) correspondant à la première zone d'émission (EA1), la première couche de boîtes quantiques (370a) remplissant la première ouverture (OP1) ;
un deuxième élément électroluminescent disposé entre le premier substrat (100) et le deuxième substrat (400) et comportant une deuxième zone d'émission (EA2) ;
une deuxième couche de filtre coloré (380b) chevauchant la deuxième zone d'émission (EA2), disposée entre la deuxième zone d'émission (EA2) et le deuxième substrat (400), et comportant une deuxième ouverture de filtre coloré (OP4) correspondant à la première ouverture (OP1) ; et
une deuxième couche de boîtes quantiques (370b) disposée entre la deuxième zone d'émission (EA2) et la deuxième couche de filtre coloré (380b).

6. Appareil d'affichage (1) selon la revendication 5, comprenant en outre :
un troisième élément électroluminescent disposé entre le premier substrat (100) et le deuxième substrat (400) et comportant une troisième zone d'émission (EA3) ;
une troisième couche de filtre coloré (380c) chevauchant la troisième zone d'émission (EA3), disposée entre la troisième zone d'émission (EA3) et le deuxième substrat (400), et comportant une troisième ouverture de filtre coloré (OP5) chevauchant à la première ouverture (OP1) ; et
une couche transmettant la lumière (370c) disposée entre la troisième zone d'émission (EA3) et la troisième couche de filtre coloré (380c).

7. Appareil d'affichage (1) selon la revendication 6, l'élément de matériau opaque (360) comportant une deuxième ouverture (OP2) correspondant à la deuxième zone d'émission (EA2) et une troisième ouverture (OP3) correspondant à la troisième zone d'émission (EA3), dans lequel la deuxième couche de boîtes quantiques (370b) remplit la deuxième ouverture (OP2), et la couche transmettant la lumière (370c) remplit la troisième ouverture (OP3).

8. Appareil d'affichage (1) selon au moins l'une des revendications 6 ou 7, dans lequel le premier élément électroluminescent, le deuxième élément électroluminescent et le troisième élément électroluminescent émettent de la lumière dans une même bande de longueurs d'onde.

9. Appareil d'affichage (1) selon au moins l'une des revendications 1 à 8, comprenant en outre :
une première couche inorganique (335) ; et
une couche organique (337) disposée entre la première couche inorganique (335) et la couche réfractive (340).

10. Appareil d'affichage (1) selon la revendication 9, comprenant en outre une deuxième couche inorganique (339), dans lequel la couche réfractive (340) est disposée directement sur la deuxième couche inorganique (339).

11. Appareil d'affichage (1) selon la revendication 9, dans lequel la couche réfractive (340) est en contact direct avec la couche organique (337).

12. Appareil d'affichage (1) selon au moins l'une des revendications 9 à 11, comprenant en outre une charge de remplissage (420) positionnée entre le premier substrat (100) et le deuxième substrat (400), ou partiellement à l'intérieur de la première structure de la couche réfractive (340), ou entre la couche réfractive (340) et la première couche de boîtes quantiques (370a), ou entre la couche organique (337) et la couche réfractive (340).

13. Appareil d'affichage (1) selon au moins l'une des revendications 1 à 12, comprenant en outre une couche protectrice (410) entre la couche réfractive (340) et la première couche de boîtes quantiques (370a).

14. Appareil d'affichage (1) selon au moins l'une des revendications 1 à 13, comprenant en outre :
un élément de matériau opaque (360) comportant une première ouverture (OP1), dans lequel la première couche de boîtes quantiques (370a) est positionnée dans la première ouverture (OP1) ; et
une colonne entretoise (365) entre la couche réfractive (340) et l'élément de matériau opaque (360).
